# EUROPÄISCHE PATENTSCHRIFT

(11) **EP 0 879 481 B1**
(45) Veröffentlichungstag und Bekanntmachung des Hinweises auf die Patenterteilung: **02.05.2002**
(21) Anmeldenummer: 97907035.6
(22) Anmeldetag: 30.01.1997
(51) Int. Cl.: H01L 29/78, H01L 29/739, H01L 29/10, H01L 29/06, H01L 21/225, H01L 21/331, H01L 21/336

(54) **DURCH FELDEFFEKT STEUERBARES HALBLEITERBAUELEMENT**
FIELD EFFECT CONTROLLED SEMICONDUCTOR COMPONENT
COMPOSANT SEMI-CONDUCTEUR COMMANDE PAR EFFET DE CHAMP

(30) Priorität: 05.02.1996 DE 19604043; 05.02.1996 DE 19604044
(43) Veröffentlichungstag der Anmeldung: 25.11.1998
(60) Teilanmeldung: 00112818.0
(73) Patentinhaber: Infineon Technologies AG, 81669 München (DE)
(72) Erfinder: TIHANYI, Jenö, D-85551 Kirchheim (DE); STRACK, Helmut, D-80804 München (DE); GEIGER, Heinrich, D-83607 Holzkirchen (DE)
(74) Vertreter: Bickel, Michael
(86) Internationale Anmeldenummer: DE9700182
(87) Internationale Veröffentlichungsnummer: WO9729518

(56) Entgegenhaltungen:
- EP-A- 0 114 435
- EP-A- 0 634 798
- DE-A- 4 107 909
- DE-A- 4 309 764
- FR-A- 2 557 367
- GB-A- 2 089 118
- US-A- 4 242 690
- US-A- 5 111 254
- US-A- 5 216 275
- US-A- 5 313 082
- PATENT ABSTRACTS OF JAPAN vol. 016, no. 347 (E-1240), 27.Juli 1992 & JP 04 107867 A (MATSUSHITA ELECTRON CORP), 9.April 1992,

## Beschreibung

Die Erfindung betrifft ein durch Feldeffekt steuerbares Halbleiterbauelement bestehend aus einem Halbleiterkörper,
a) mit einer inneren Zone vom ersten Leitungstyp, die an eine der Oberflächen des Halbleiterkörpers angrenzt,
b) mit einer Drainzone, die an die Innenzone angrenzt,
c) mit mindestens einer Basiszone vom zweiten Leitungstyp, die in die besagte Oberfläche des Halbleiterkörpers eingebettet ist,
d) mit mindestens einer Sourcezone vom ersten Leitungstyp, welche in die Basiszone eingebettet ist,
e) mit mindestens einer Sourceelektrode, die jeweils eine Basiszone und die darin eingebetteten Sourcezonen kontaktiert und
f) mit einer gegen den gesamten Halbleiterkörper isolierten Gateelektrode.

Derartige vertikale durch Feldeffekt steuerbare Halbleiterbauelemente sind seit langem Stand der Technik. Zum einen sind sie als VMOS-Feldeffekttransistoren bekannt, sofern die Drainzone, die an die Innenzone angrenzt, vom selben Leitungstyp wie die Innenzone ist. Zum anderen sind solche durch Feldeffekt steuerbare Halbleiterbauelemente als IGBTs bekannt, sofern die Drainzone als Anodenzone ausgebildet ist und vom entgegengesetzten Leitungstyp ist wie die Innenzone.

Die eingangs genannten Halbleiterbauelemente sind ausführlich in dem Buch Jens Peer Stengl; Jenö Tihanyi: Leistungs-MOS-FET-Praxis, 2. Auflage, Pflaumverlag, München, 1992 erörtert.

Allen eingangs genannten Halbleiterbauelementen ist der Nachteil inhärent, daß der Durchlaßwiderstand Rₒₙ der Drain-Source-Laststrecke mit zunehmender Spannungsfestigkeit des Halbleiterbauelements zunimmt, da die Dicke der Innenzone bzw. der Driftzone zunehmen muß. Bei VMOS-MOSFETs liegt bei einer Spannung von 50 V der flächenbezogene Durchlaßwiderstand Rₒₙ bei ungefähr 0,20 Ohm/m² und steigt bei einer Sperrspannung von 1000 V beispielsweise auf einen Wert von ca. 10 Ohm/m² an.

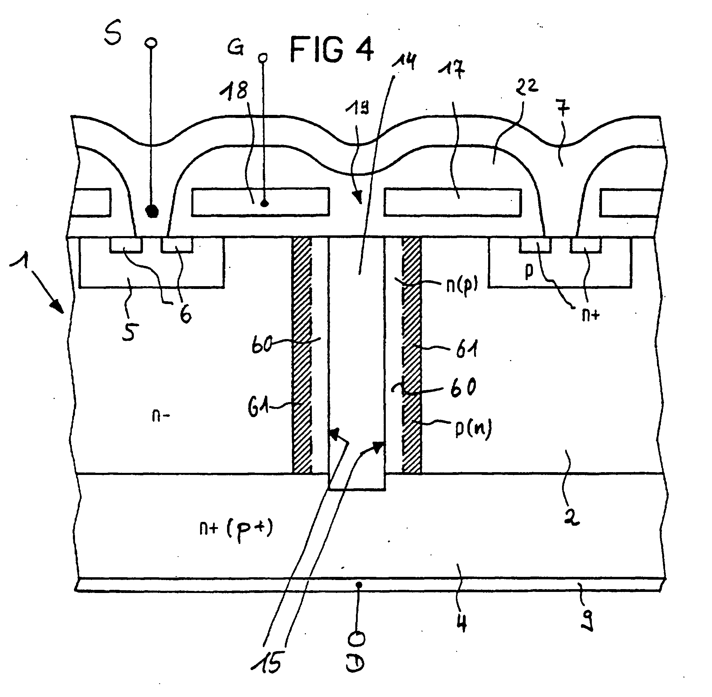

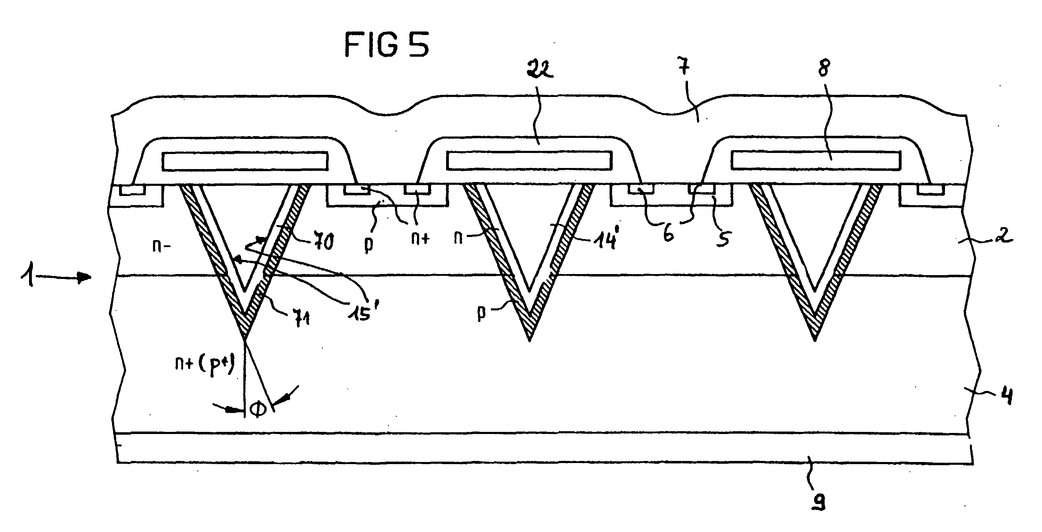

Um diesen Nachteil zu beseitigen, wird in der US 5,216,275 ein vertikaler MOSFET vorgestellt, bei dem statt einer homogenen beispielsweise epitaktisch aufgewachsenen Innenzone alternierend Schichten vom ersten und vom zweiten Leitungstyp vorliegen. Der prinzipielle Aufbau ist dort insbesondere in den Figuren 4 und 5 sowie den dazu gehörigen Teilen der Beschreibung aufgezeigt. Insbesondere werden dort die abwechselnden p- und n-Schichten jeweils mit den Basiszonen und den Drainzonen verbunden. Dies führt jedoch zu einer starken Einschränkung im Design eines Halbleiterbauelements, da die Randbereiche nicht mehr frei gestaltet werden können.

Dokument DE 43 09 764 C2 beschreibt ein als Kompensationsbauelement ausgebildetes Leistungshalbleiterbauelement, dessen Innenzone eine Vielzahl von Ausräumzonen und Komplementärausräumzonen aufweist, wobei die Gesamtmenge der Dotierung von Ausräumzonen und Komplementärausräumzonen in etwa gleich ist. Das Halbleiterbauelement ist jedoch nicht für in Trenchtechnologie ausgebildete Bauelemente mit Zellenstruktur geeignet. Solche herkömmlichen vertikalen Halbleiterbauelemente weisen gegenüber Halbleiterbauelementen in Trenchtechnologie einen vergleichsweise sehr viel höheren Einschaltwiderstand sowie eine geringere Integrationsdichte auf.

Die Dokumente US 5,313,082 und EP 0 114 435 B1 beschreiben jeweils ein laterales Halbleiterbauelement bestehend aus einem Feldeffekttransistor und einem JFET, deren gesteuerte Strecke in Reihe geschaltet ist. Als Steuerelektrode des JFET dient eine Halbleiterschicht, die sandwichartig zwischen zwei Schichten entgegengesetzten Leitungstyps angeordnet ist. Durch diese Anordnung der Steuerelektrode weist die Halbleiterstruktur einen verbesserten Einschaltwiderstand bei gleicher Sperrfestigkeit auf.

Weitere laterale Halbleiterstrukturen, die geeignet sind den Einschaltwiderstand zu reduzieren, sind in den Dokumenten EP 634 798 A1 und der JP-A-4 107 867 beschrieben.

Ausgehend von dem Stand der Technik der DE 43 09 764 C2 liegt der vorliegenden Erfindung daher die Aufgabe zugrunde, ein gattungsgemäßes Halbleiterbauelement bereitzustellen, welches auch in Trenchtechnologie ausbildbar ist. Ferner sollen einfache Verfahren zur Herstellung solcher Halbleiterbauelemente angegeben werden.

Die bauelementbezogene Aufgabe wird durch ein gattungsgemäßes Halbleiterbauelement mit den Merkmalen des Anspruchs 1, die verfahrensbezogenen Aufgaben durch Verfahren mit den Merkmalen der Ansprüche 12 und 13 gelöst.

Die Erfindung weist den Vorteil auf, daß durch einfaches Einbringen von gepaarten Ausräumzonen und Komplementärausräumzonen, insbesondere entlang des Strompfades, zum einen durch die Komplementärausräumzonen eine gute Leitfähigkeit gewährleistet wird und sich zum anderen bei Erhöhung der Drainspannung diese Bereiche gegenseitig ausräumen, wodurch eine hohe Sperrspannung gesichert bleibt.

Liegt an den so ausgebildeten Halbleiterbauelementen eine Sperrspannung an, so bildet sich ausgehend vom pn-Übergang zwischen der Innenzone und der oder den Basiszonen bei den vertikalen Halbleiterbauelementen eine Raumladungszone aus, deren Ausdehnung mit steigender Sperrspannung wächst. Stößt die Raumladungszone an die Ausräumzonen an, so werden diese über das ausgeräumte Gebiet der Innenzone hochohmig an die Basiszonen angeschlossen. Bei weitersteigender Sperrspannung dehnt sich die Raumladungszone weiter aus, so daß auch ein Teil der Ladungsträger aus den Ausräumzonen und Komplementärausräumzonen ausgeräumt wird. Bei weiterer Steigerung der Sperrspannung sind dann die Ladungsträger aus einem großen Teil der Innenzone und aus den Ausräumzonen und Komplementärausräumzonen vollständig ausgeräumt. Die Raumladungszone wird dadurch in Richtung der Drain- bzw. der Anodenzone verlagert. Bei maximal anliegender Spannung liegen die Ausräumzonen und die Komplementärausräumzonen vollständig in der Raumladungszone. Analog dazu ist die Funktion der Ausräumzonen und Komplementärausräumzonen bei den lateralen MOSFETs.

Da die Gesamtmenge an Dotierung in den Ausräumzonen in etwa der Gesamtmenge an Dotierung in den Komplementärausräumzonen entspricht, wird gewährleistet, daß bei Erhöhung der Drainspannung die derart gebildeten p--n-Bereiche sich gegenseitig vollständig ausräumen, d.h. wie eine einzige Isolatorzone verhalten, wodurch eine hohe Sperrspannung gesichert bleibt.

In einer Ausführungsform der vorliegenden Erfindung sind die Ausräumzone und die Komplementärausräumzone in der Innenzone jeweils paarweise angeordnet. Typischerweise weisen dann die paarweise eingebrachten Ausräumzonen und Komplementärausräumzonen in der Innenzone einen Abstand voneinander größer oder gleich 0 und kleiner oder gleich der Breite der Raumladungszone auf.

In einer alternativen Ausführung der vorliegenden Erfindung ist in die Innenzone eine einzige Komplementärausräumzone eingebracht, in die eine Vielzahl von Ausräumzonen eingebracht sind, wobei dann typischerweise der Abstand der Ausräumzonen innerhalb der Komplementärausräumzone zueinander kleiner gleich der Breite der Raumladungszone zwischen der Ausräumzone und der Komplementärausräumzone ist.

Bei dieser Ausführungsform können die in die Komplementärausräumzone eingebrachten Ausräumzonen in etwa kugelförmige, quaderförmige oder irreguläre Gestalt aufweisen.

Zweckmäßigerweise entspricht in einer Weiterbildung dieser alternativen Ausführungsform der vorliegenden Erfindung die Komplementärausräumzone der gesamten Innenzone.

Schließlich betrifft die Erfindung noch ein Verfahren zum Herstellen von paarweise angeordnetenAusräumzonen/Komplementärausräumzonen. Erfindungsgemäß wird dabei auf ein Substrat eine erste Epitaxieschicht aufgebracht, die p-Dotierstoffe und n-Dotierstoffe in etwa gleichen Mengen enthält, wobei die Diffusionskoeffizienten der beiden Dotierelemente sich deutlich voneinander unterscheiden. In die erste Epitaxieschicht werden danach Gräben geätzt und diese Gräben werden mit einer zweiten hochohmigen Epitaxieschicht aufgefüllt. Das so prozessierte Substrat wird daraufhin einem Temperschritt unterworfen, bei dem die beiden unterschiedlich schnell diffundierenden Dotierelemente der ersten Epitaxieschicht in die zweite Epitaxieschicht eindiffundieren können. Aufgrund des unterschiedlichen Diffusionsverhaltens bilden sich danach paarweise Ausräumzonen und Komplementärausräumzonen an den Grabenrändern aus.

Die Erfindung ist in der Zeichnung beispielsweise veranschaulicht und im folgenden anhand der Zeichnung beschrieben.

Es zeigen:
- Figur 1: einen Teilschnitt durch einen Vertikal-MOSFET der -in entsprechend mit A, B, C gekennzeichneten Bereichen- verschiedene Realisierungsmöglichkeiten aufzeigt,
- Figur 2: einen Teilschnitt durch einen alternativen V-MOSFET.
- Figur 3: einen Teilschnitt durch einen erfindungsgemäßen V-MOSFET mit einer Grabenstruktur,
- Figur 4: einen Teilschnitt durch einen weiteren erfindungsgemäßen V-MOSFET mit Grabenstruktur,
- Figur 5: einen Teilschnitt durch einen erfindungsgemäßen V-MOSFET mit V-formiger Grabenstruktur,
- Figur 6: einen Teilschnitt durch einen lateralen MOSFET,
- Figur 7a: bis 7d zeigen jeweils teilweise Schnitte, anhand derer die charakteristischen Verfahrensschritte zur Herstellung eines vertikalen MOSFET gezeigt werden,
- Figur 8a: bis 8b jeweils teilweise Schnitte anhand derer alternative Verfahrensschritte zur Herstellung eines erfindungsgemaßen vertikalen MOSFET gezeigt werden, und

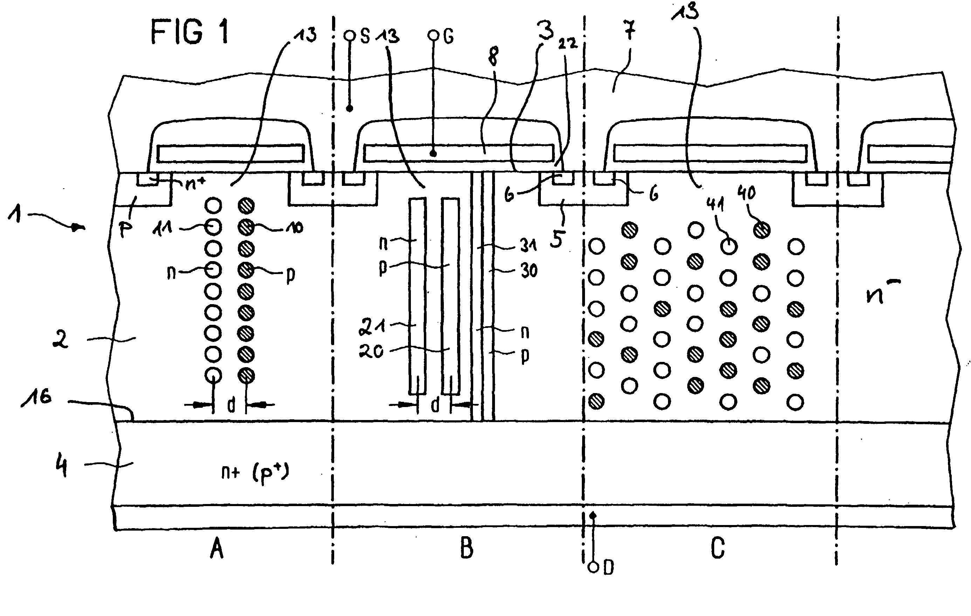

In den Figuren 1 bis 5 ist der Halbleiterkörper des Halbleiterbauelements mit 1 bezeichnet. Er hat eine sourceseitige Oberfläche 3 und eine drainseitige Oberfläche 16. Er weist eine n⁻-dotierte Innenzone 2 auf, die an die Oberfläche 3 des Halbleiterkörpers 1 angrenzt. In die Oberfläche 3 sind mehrere Basiszonen 5 eingebettet. Diese Basiszonen 5 weisen zellenförmige Strukturen auf. Solche Zellenstrukturen können streifenförmig, sechseckig, dreieckig, rund oder viereckig sein. Die Basiszonen 5 haben den der Innenzone 2 entgegengesetzten Leitungstyp, d.h. sie sind im gezeigten Fall p-dotiert. In die Basiszonen 5 sind jeweils zwei stark n-dotierte Sourcezonen 6 eingebettet. Die Basiszonen 5 und die Sourcezonen 6 sind von Sourceelektroden 7 kontaktiert, die aus Metall, beispielsweise Aluminium bestehen.

An die andere Seite der Innenzone 2 grenzt eine stark n-dotierte Drainzone 4, bzw. im Fall eines IGBTs eine stark p-dotierte Anodenzone an. Diese ist über eine Metallisierung mit einer Drainelektrode 9 versehen.

Die Basiszonen 5 sind über Zwischenzellenzonen 13 räumlich voneinander getrennt.

Isoliert durch ein Gateoxid über der sourceseitigen Oberfläche 3 ist eine Gateelektrode 8 angeordnet. Die Gateelektrode 8 kann aus hochdotiertem Polysilizium bzw. aus Metall bestehen.

In Figur 1 werden verschiedene Ausführungsformen von Vertikal-MOSTETS der Übersichtlichkeit halber in einer einzigen Figur gezeigt.

Figur 1 zeigt in den Zwischenzellenzonen 13 innerhalb der Innenzone 2 verschiedene Ausräumzonen, Komplementärausräumzonen 10, 11 bzw. 20, 21 bzw. 30, 31 bzw. 40, 41 eingebracht. Diese können miteinander in Kontakt stehen, d.h. sie können einander berühren, sie müssen einander jedoch nicht berühren. Sofern sie einander berühren, was bei der gezeigten Komplementärausräumzone 30 und der gezeigten Ausräumzone 31 der Fall ist, bilden sie einen pn-Übergang.

Alle gezeigten Ausräumzonen sind p-dotiert und alle gezeigten Komplementärausräumzonen sind n-dotiert. Die Ausräumzonen und Komplementärausräumzonen können, wie im Bereich A mit den Bezugszeichen 10, 11 dargestellt, kugelförmig ausgebildet sein und sich entlang des Strompfades der Drain-Source-Laststrecke erstrecken. Im Bereich B sind die Komplementärausräumzonen 21, 31 und Ausräumzonen 20, 30 fadenförmig bzw. streifenförmig ausgebildet. Dort sind die Ausräumzonen 20 und Komplementärausräumzonen 21 innerhalb der Innenzone 2 "floatend", d.h. frei schwebend, ausgeführt und füllen nur einen Teil der Innenzone 2 aus. Sie können aber auch -wie durch die Bezugszeichen 30, 31 angedeutet- von der sourceseitigen Oberfläche 3 bis zur drainseitigen Oberfläche 16 und/oder in die Drainzone 4 hineinreichen. Wie im Bereich B gezeigt, kann der Abstand d der Ausräumzonen und Komplementärausräumzonen zueinander größer oder gleich 0 sein.

Im Bereich C ist eine weitere Ausführungsform dargestellt, bei der eine statistische Verteilung der Ausräumzonen und Komplementärausräumzonen 40, 41 vorgesehen ist. Dabei kann die Gestalt der Ausräumzonen und Komplementärausräumzonen 40, 41 sowie auch die Dotierungsverteilung innerhalb der einzelnen Ausräumzonen bzw. Komplementärausräumzonen unregelmäßig sein.

Erfindungswesentlichfür die nachfolgend beschriebene Erfindung ist, daß die Gesamtmenge der Dotierung der Ausräumzonen in etwa der Gesamtmenge der Dotierung der Komplementärausräumzonen entspricht. Ferner ist zu beachten, daß die Summe der Volumenausdehnungen der eingebrachten Ausräumzonen ungefähr gleich oder kleiner der der Komplementärausräumzonen ist.

Des weiteren sollte im Fall der Anordnung gemäß dem Bereich C die durchschnittliche Konzentration der verteilten Ausräumzonen in etwa gleich oder größer der der eingebrachten Komplementärausräumzonen sein.

Der Abstand d zwischen den einzelnen Ausräumzonen und Komplementärausräumzonen sollte vorzugsweise kleiner als die Breite der Raumladungszone zwischen den Komplementärausräumzonen und Ausräumzonen bei der Durchbruchsspannung zwischen den benachbarten Ausräumzonen und Komplementärausräumzonen sein. Der Abstand d kann aber wie im Bereich B gezeigt, auch zu 0 werden.

Nachfolgend wird die Funktionsweise der in Figur 1 gezeigten Strukturen näher erläutert.

Bei kleiner Drainspannung ist die Leitfähigkeit gut, da die Komplementärausräumzonen niederohmig sind. Wird die Drainspannung erhöht, werden bei moderater Spannung, z.B. einer Spannung kleiner 30 V, die Ausräumzonen bzw. Komplementärausräumzonen gegenseitig ausgeräumt. Bei einer weiteren Spannungserhöhung wird nun die vertikale Feldstärke weiter erhöht und die Innenzone 2 nimmt die Spannung auf.

### Im einzelnen erfolgt dieser Vorgang folgendermaßen:

Die Ausräumung startet von der sourceseitigen Oberfläche 3 unter der Gateelektrode 8 und in den Basiszonen 5 eingebetteten Sourcezonen 6. Sie schreitet dann in die Ausräumzonen bzw. die Komplementärausräumzonen voran. Wenn die Raumladungszone die ersten Ausräumzonen erreicht, bleiben diese Gebiete auf der Spannung, die das Potential der Raumladungszone erreicht hat. Dann wird die nächste Umgebung in Richtung der Drainzone 1 ausgeräumt. Dieser Vorgang wiederholt sich von Schicht zu Schicht. Auf diese Weise schreitet die Raumladungszone voran, bis die Zone unterhalb der eingebrachten Dotierungen innerhalb der Innenzone 2 erreicht wird. Insgesamt wird dann die Raumladungszone so aufgebaut, als ob die zusätzlich eingebrachten Ausräumzonen und Komplementärausräumzonen nicht vorhanden wären.

Die Spannungsfestigkeit wird dabei nur durch die Dicke der Innenzone 2 bestimmt. Somit kann die erfindungsgemäße Anordnung beide Erfordernisse erfüllen, nämlich einen niederohmigen Durchlaßwiderstand Rₒₙ bei gleichzeitig hoher Spannungsfestigkeit.

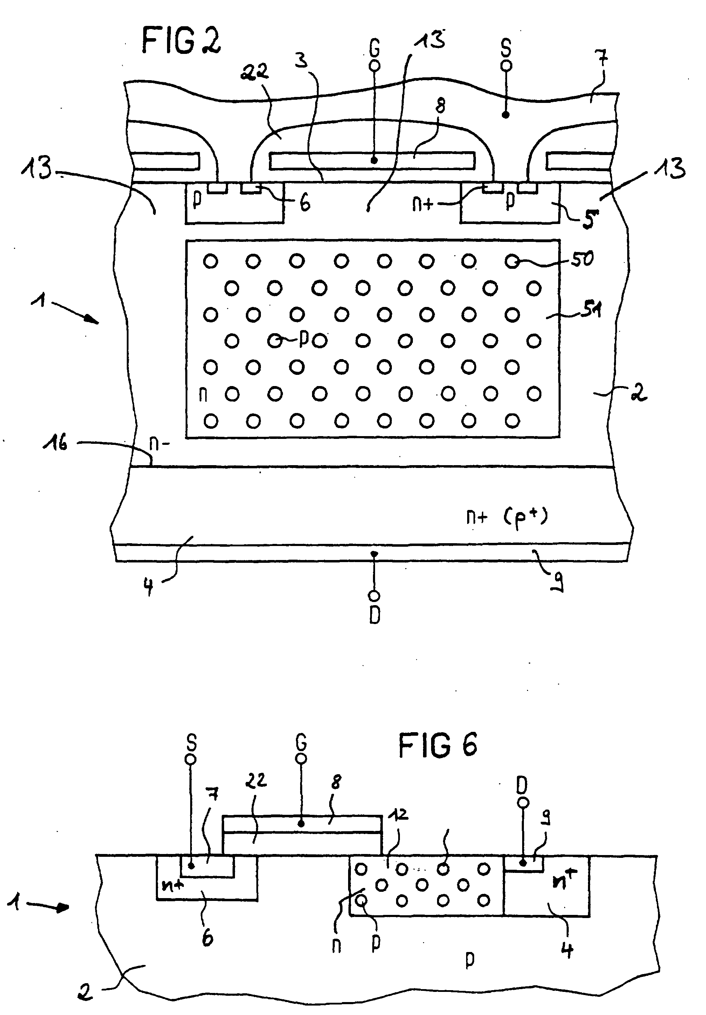

In der Figur 2 ist eine alternative Ausführungsform eines V-MOSFETs gezeigt. Dort ist in eine n⁻-dotierte Innenzone 2 eine sich von den Zwischenzellenzonen 13 unter die Basiszonen 5 erstreckende n-dotierte Komplementärausräumzone 51 eingebracht. Innerhalb dieser Komplementärausräumzone 51 sind eine Vielzahl von p-dotierten Ausräumzonen 50 eingebracht. Die Verteilung dieser Ausräumzonen 50 kann statistisch oder regelmäßig sein. Die Ausräumzonen 50 können dabei eine beliebige Form aufweisen, wobei die in der Figur 2 gezeigten Ausräumzonen 50 eine in etwa kugelförmige Gestalt aufweisen. Auch hier ist die Gesamtmenge der Dotierungen in den verteilten Ausraumzonen 50 in etwa gleich der Gesamtmenge der Dotierungen in der n-dotierten Komplementärausräumzone 51. Ferner ist der Abstand zwischen den Ausräumzonen 50 kleiner als die Breite der Raumladungszone zwischen den Ausräumzonen 50 und der Komplementärausräumzone 51 bei der Durchbruchspannung zwischen den Ausräumzonen 50 und der Komplementärausräumzone 51.

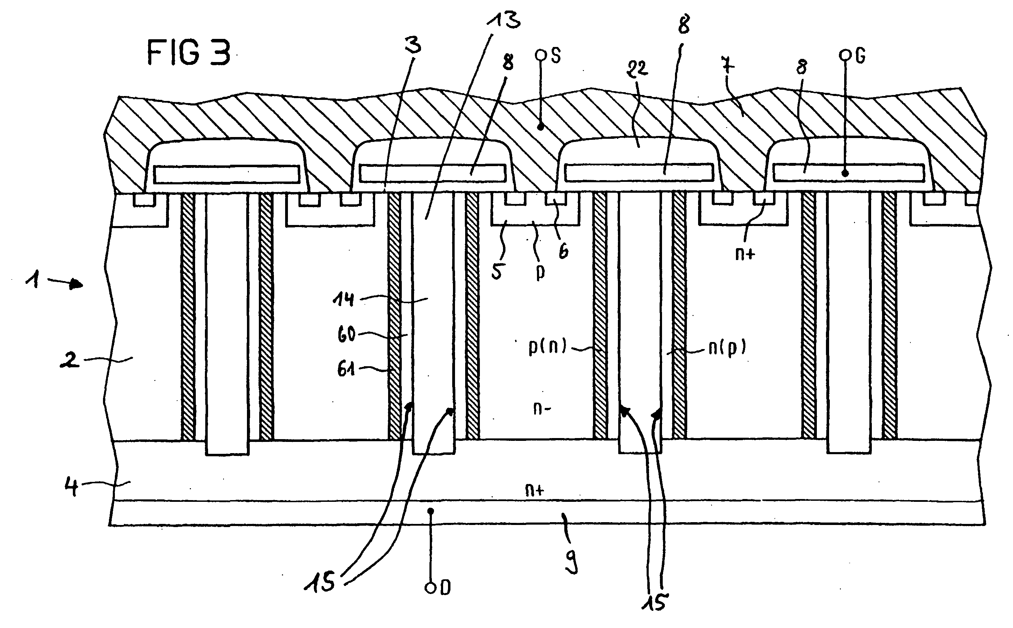

Die Figur 3 zeigt ein Ausführungsbeispiel eines erfindungsgemäßen V-MOSFETs. Dieser MOSFET unterscheidet sich von den in den Figuren 1 bzw. 2 gezeigten in der Ausgestaltung der Innenzone 2. Unterhalb der durch Gateoxid 22 isolierten Gateelektroden 8 erstrecken sich hier von der sourceseitigen Oberfläche 3 der Innenzone 2 bis in die Drainzone 4 hinein im Bereich der Zwischenzellenzonen 13 vertikale Gräben 14. Diese Gräben 14 sind teilweise oder vollständig mit isolierendem Material, z.B. Siliziumoxid und/oder schwach dotiertem Polysilizium aufgefüllt. Auch eine Kombination von mehreren übereinanderliegenden Isolationsschichten mit dazwischenliegenden schwach dotiertem Polysilizium ist möglich.

Die so mit isolierendem Material aufgefüllten Gräben 14 sind von der Innenzone 2 über eine n-dotierte Komplementärausräumzone 61 getrennt, welche mit einer p-dotierten Ausräumzone 60 versehen ist. Die so von den Ausräumzonen 60 und Komplementärausräumzonen 61 erzeugten Grabenumhüllungen sind in ihrer Dotierung dabei so bemessen, daß bei einer U_{D}-Spannung, welche kleiner als die Durchbruchspannung zwischen den Ausräumzonen 60 und Komplementärausräumzonen 61 ist, die Ausräumzone 60 und die Komplementärausräumzone 61 nahezu vollkommen ausgeräumt werden.

Der Querschnitt der Gräben 14 kann rund, streifenförmig oder beliebig sein. Die Gräben 14 müssen sich dabei nicht bis in die Drainzone 4 erstrecken, vielmehr ist der Tiefenverlauf frei wählbar. Wird z.B. ein runder Grabenquerschnitt gewählt, so erhalten die den mit isolierendem Material aufgefüllten Graben 14 umhüllenden Ausräumzonen 60 und Komplementärausräumzonen 61 eine quasi zylindrische Form.

Die Reihenfolge der Dotierung der Ausräumzonen 60 und Komplementärausräümzonen 61 zwischen der Innenzone 2 und dem Graben 14 ist dabei beliebig, d.h. die Komplementärausräumzone 60 kann sowohl zwischen Graben 14 und Komplementärausräumzone 61 als auch zwischen Komplementärausräumzone 61 und Innenzone 2 angeordnet sein.

Ferner ist es auch möglich, nur einen Teil der Grabenwände 15 mit Ausräumzonen 60 und Komplementärausräumzonen 61 zu belegen.

Die Figur 4 zeigt ein weiteres Ausführungsbeispiel entsprechend der in Figur 3 dargestellten Anordnung. Der Unterschied zur Anordnung gemäß Figur 3 besteht in der Ausgestaltung der Gateelektrode. Im Gegensatz zu der in Figur 3 dargestellten Anordnung ist hier die Gateelektrode zweigeteilt bzw. weist eine Gateaussparung 19 auf, die die Gateelektrode in einen ersten Teilbereich 17 und einen zweiten Teilbereich 18 aufteilt. Sinn dieser Anordnung ist, daß durch eine so ausgebildete Gateelektrode der darunter befindliche Graben 14 maskiert wird. Dadurch kann ein vereinfachtes Herstellverfahren des Grabens 14 erzielt werden. Wie bei bekannten Strukturen, bei denen das Gate zur Maskierung bestimmter Bereiche während des Herstellverfahrens dient, wird hier durch die Form des Gates die Ausbildung des Grabens 14 entsprechend der Formgebung der Gateaussparung 19 eingestellt.

Figur 5 zeigt ein weiteres Ausführungsbeispiel eines vertikalen MOSFETs. Der hier gezeigte V-MOSFET entspricht ebenfalls im wesentlichen der in Figur 3 wiedergegebenen Struktur mit dem Unterschied, daß der Graben 14' hier als annähernd V-förmiger Graben ausgebildet ist. Dementsprechend sind auch die Ausräumzonen und Komplementarausräumzonen V-förmig ausgebildet. Ebenso ist es jedoch auch denkbar, den Scheitel bzw. Umkehrpunkt des Grabens 14' U-förmig auszubilden. Ein derartiger Trench-V-MOSFET ist leicht herstellbar, wenn die Gräben wie in Figur 5 dargestellt, V-förmig ausgebildet sind, wobei ein sehr kleiner Winkel Φ, vorzugsweise 5° bis 10° verwendet wird. Dann können die Grabenwände 15' durch Ionenimplantation mit einem Einfallswinkel von 0° mit hoher Genauigkeit und Gleichmäßigkeit belegt werden. Die unterschiedlichen Dotierungen der Ausräumzonen und Komplementärausräumzonen können aus der Grabenwand durch eine oder mehrere Hochtemperaturbehandlungen in das einkristalline Silizium der Drainzone 4 und der Innenzone 2 eingetrieben werden. Es ist hier auch denkbar, daß jeweils nur eine Grabenseitenwand mit einer Ausräumzone bzw. einer Komplementärausräumzone belegt wird.

Figur 6 zeigt ein weiteres nicht erfindungsgemäßes Ausführungsbeispiel, welches einen lateralen MOSFET darstellt. Wie aus der Figur 6 ersichtlich ist, besteht der laterale MOSFET aus einem Halbleiterkörper 1 mit einer p-dotierten Innenzone 2. In die p-dotierte Innenzone 2 ist auf deren Oberfläche 3 eine n-dotierte Sourcezone 6 eingebracht. In der n-dotierten Sourcezone 6 befindet sich eine Sourceelektrode 7 aus Metallsilizid, welche mit einem Sourceanschluß S verbunden ist. Ferner ist eine ebenfalls n-dotierte Drainzone 4 in die Oberfläche 3 des Halbleiterkörpers 1 eingebracht. Die n-dotierte Drainzone 4 weist wiederum eine Drainelektrode 9 aus Metallsilizid auf, die einen Drainanschluß D aufweist. Zwischen Sourcezone 6 und Drainzone 4 befindet sich eine Driftzone 12, die schwach n-dotiert ist. In diese Driftzone 12 sind wiederum Ausräumzonen 10 eingebracht, die p-dotiert sind. Der Abstand der einzelnen p-dotierten Ausräumzonen 10 zueinander ist vorzugsweise wiederum kleiner als die Breite der Raumladungszone zwischen der eingebrachten p-dotierten Ausräumzonen 10 und der schwach n-dotierten Driftzone 12. Auch hier ist die Gesamtmenge der Dotierungen in den verteilten p-dotierten Ausräumzonen 10 in etwa gleich mit der Gesamtmenge der Dotierungen in der schwach n-dotierten Driftzone 12.

Über dem Halbleiterkörper befindet sich in bekannter Weise eine Gateelektrode 8, die gegenüber dem gesamten Halbleiterkörper 1 über ein Gateoxid 22 isoliert ist. Die Gateelektrode 8 kann auch in bekannter Weise so ausgestaltet werden, daß der Abstand zwischen der Gateelektrode 8 und der p-dotierten Innenzone 2 von der Sourcezone 6 in Richtung der Drainzone 4 zunimmt.

Die Funktionsweise einer derartigen lateralen Struktur wird im folgenden näher erläutert. Bei kleiner Drainspannung ist die Leitfähigkeit gut, da die n-dotierte Driftzone 12 niederohmig ist. Wird die Drainspannung moderat erhöht, so räumen sich die Ausräumzonen 10 und die Driftzone 12 gegenseitig aus. Bei einer weiteren Spannungserhöhung wird nun die laterale Feldstärke derart erhöht, daß das ganze Volumen der Driftzone 12 ausgeräumt wird. Der zwischen der Driftzone 12 und der Sourcezone 6 liegende Bereich der Innenzone 2 nimmt dann die weitere Spannung auf.

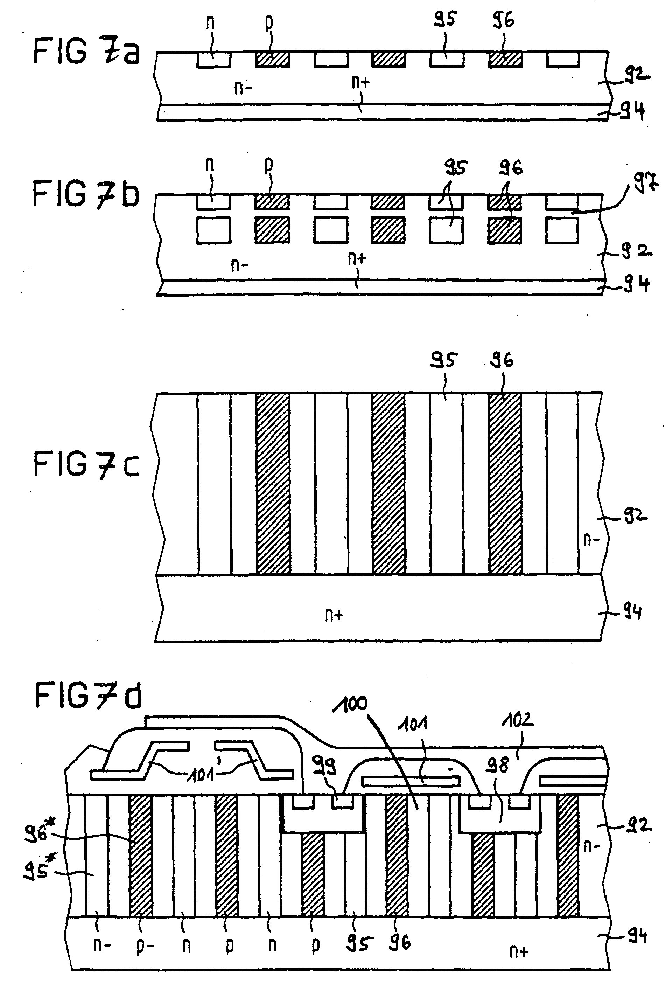

Die Figuren 7a bis 7d zeigen ein mögliches Herstellverfahren für ein vertikales Halbleiterbauelement. Auf einem n⁻-dotierten Substrat 94 wird eine erste dünne n⁻-dotierte Schicht 92 epitaktisch aufgewachsen. Diese wird beispielsweise durch entsprechende Maskierung und Ionenimplantation mit sich abwechselnden n-dotierten bzw. p-dotierten Bereichen 95, 96 dotiert. Die Dotierung kann selbstverständlich auch durch andere bekannte Verfahren erfolgen.

Danach wird, wie in Figur 7b zu sehen ist, eine weitere n⁻dotierte Schicht 97 epitaktisch aufgebracht. Durch Wiederholen dieses Schrittes wird durch eine mehrstufige Epitaxieabscheidung schließlich die n⁻-dotierte Zone 92 bis zu den noch einzubringenden Basiszonen 98 vervollständigt.

Je nach verwendeten Masken können pro Schicht die unterschiedlichsten Strukturen gebildet werden. Die Dotierungen der Ausräumzonen 95 und Komplementärausräumzonen 96 können z.B. derart gewählt werden, daß sich die einzelnen Ausräumzonen 95 und Komplementärausraumzonen 96 einer Schicht nach einer Hochtemperaturbehandlung mit denjenigen der darunterliegenden Schicht verbinden, so daß sich insgesamt, wie in Figur 7c dargestellt, streifenförmige Ausräumzonen 95 und streifenförmige Komplementärausräumzonen 96 ausbilden. Die in den einzelnen Schichten dotierten Ausräumzoneh 95 und Komplementärausräumzonen 96 können jedoch auch voneinander getrennt sein, wie es in den Bereichen A und C in den in der Figur 1 dargestellt ist. Durch entsprechende Wahl der Masken können auch statistische räumliche Verteilungen der einzelnen Gebiete erreicht werden.

Schließlich werden die Basiszonen 98 und die Sourcezonen 99 eine weitere aufgebrachte Epitaxieschicht eingebracht und in den übrigen Bereiche kann z.B. eine weitere Dotierung von Ausräumzonen und Komplementärausräumzonen erfolgen, so daß sich die streifenförmigen Ausräumzonen 95 und Komplementärausräumzonen 96 in den Zwischenzellenzonen 100 bis zur Oberfläche erstrecken.

Die am Randbereich eingebrachten Ausräumzonen und Komplementärausräumzonen in Figur 7d sind mit 95' und 96' bezeichnet. Diese am Rand liegenden Ausräumzonen 95' und Komplementärausräumzonen 96' werden vorzugsweise schwächer als die im Inneren des Halbleiterkörpers liegenden übrigen Ausräumzonen 95 und Komplementärausräumzonen 96 dotiert. Es folgen nun weitere Schritte zur Aufbringung der Gateelektrode 101 bzw. der Randgateelektrode 101' und der Sourceelektrode 102 in bekannter Weise.

In den Figuren 8a bis 8c wird ein erfindungsgemäßes Verfahren zur Herstellung eines vertikalen durch Feldeffekt steuerbaren Halbleiterbauelements gemäß der vorliegenden Erfindung gezeigt. Dort geschieht das Einbringen der Ausräumzonen 95' und Komplementärausräumzonen 96' über den Umweg einer ersten speziellen epitaktisch abgeschiedenen Schicht. Auf einem Substrat 94' wird eine erste Epitaxieschicht 92' aufgebracht, die gleichzeitig p-Dotierstoffe und n-Dotierstoffe in etwa gleichen Mengen enthält. Dabei sind die Dotierstoffe so gewählt werden, daß die Diffusionskoeffizienten der beiden Dotierelemente sich deutlich voneinander unterscheiden. Besonders geeignet sind als p-Dotierstoff Bor und als n-Dotierstoff Arsen, da der Diffusionskoeffizient von Arsen etwa 10 mal größer ist als der von Bor.

Danach werden Gräben 93' in den gewünschten geometrischen Ausmaßen in diese erste Epitaxieschicht 92' geätzt, wobei es auf eine extrem gute Reproduzierbarkeit bei diesem Schritt nicht ankommt.

Danach werden die Gräben 93' mit einer zweiten hochohmigen Epitaxieschicht 97' aufgefüllt, wobei diese zweite Epitaxieschicht 97' den Graben in der Weise ausfüllt, daß keinerlei Kristallstörungen auftreten. Dies ist in Figur 8b veranschaulicht.

Schließlich wird der so prozessierte Halbleiterkörper danach einem Temperaturschritt unterworfen, bei dem die beiden unterschiedlich schnell diffundierenden Elemente der ersten Epitaxieschicht 92', z.B. also die Dotierstoffe Arsen und Bor, in die zweite Epitaxieschicht 97' eindiffundieren können. Aufgrund des unterschiedlichen Diffusionskoeffizienten reichert sich der besser diffundierende Dotierstoff, im vorliegenden Beispiel Bor, in der zweiten Epitaxieschicht 97' an, während der schlechter diffundierende Dotierstoff, im vorliegenden Beispiel Arsen, in der ersten Epitaxieschicht 92' am Rand zum Graben überwiegt.

Nach diesem Temperschritt, der auch mit den nachfolgenden Schritten des Herstellungsprozesses für das zu fertigende Halbleiterbauelement kombiniert werden kann, ist am Rande des Grabens jeweils eine Ausräumschicht 95' und eine Komplementärausräumschicht 96' vorhanden. Die Gesamtmenge von p-Dotierung bzw. n-Dotierung ist somit immer etwa gleich groß, da die ursprünglich eingebrachte Dotierung durch den beschriebenen Prozeß nun anders verteilt wird. Der Prozeß ist demnach quasi selbstjustierend.

Die Einbringung der Basiszonen, Sourcezonen, sowie die Aufbringung der Gateelektrode und die Ausbildung der Randbereiche erfolgt analog zu dem Verfahren, das oben beschrieben wurde.

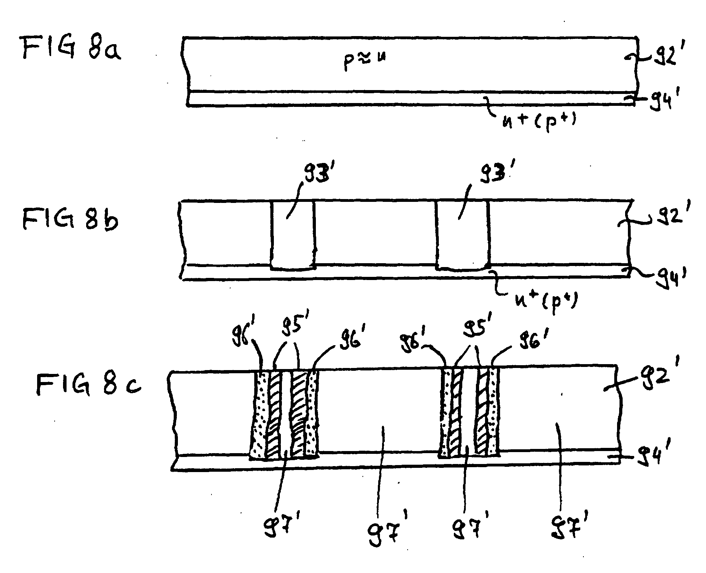

Die in den Figuren 7 und 8 gezeigten Verfahren lassen sich leicht zur Herstellung von lateralen MOSFETs modifizieren,

Zusammenfassend läßt sich sagen, daß durch die vorliegende Erfindung vertikale MOSFETs sowie IGBTs mit niedrigem Durchlaßwiderstand Rₒₙ bei gleichzeitig hoher Sperrspannung vorgesehen werden können. Wesentlich ist die Ausbildung von paarweisen p- bzw. n-dotierten Bereichen, welche strukturiert oder statistisch eingebracht sind, wobei vorzugsweise streifenförmige Bereiche vorgesehen sind, die entlang des Strompfades der Laststrecke ausgebildet sind. Die vorliegende Erfindung ist dabei sowohl bei MOSFETs vom p-Kanal wie auch bei MOSFETs vom n-Kanal oder auch entsprechenden IGBTs anwendbar.

### Bezugszeichenliste

- 1 =: Halbleiterkörper
- 2 =: Innenzone
- 3 =: sourceseitige Oberfläche
- 4 =: Drainzone
- 5 =: Basiszone
- 6 =: Sourcezone
- 7 =: Sourceelektrode
- 8 =: Gateelektrode
- 9 =: Drainelektrode
- 10 =: Ausräumzone
- 11 =: Komplementärausräumzone
- 12 =: Driftzone
- 13 =: Zwischenzellenzone
- 14 =: Graben
- 15 =: Grabenwand
- 16 =: drainseitige Oberfläche
- 17 =: Gateaussparung
- 18 =: erster Gatebereich
- 19 =: zweiter Gatebereich
- 20,30,40,50,60,70 =: Ausräumzone
- 21,31,41,51,61,71 =: Komplementärausräumzone
- 22 =: Gateoxid
- 92 =: erste n⁻-Epitaxieschicht
- 92' =: erste Epitaxieschicht
- 93' =: Graben
- 94 =: n⁻-Substrat
- 94' =: Substrat
- 95 =: p-dotierter Bereich = Ausräumzone
- 95' =: Ausräumschicht
- 95* =: Randausräumzone
- 96 =: n-dotierter Bereich = Komplementärausräumzone
- 96' =: Komplementärausräumschicht
- 96* =: Randkompanz
- 97 =: zweite n⁻-Epitaxieschicht
- 97' =: zweite Epitaxieschicht
- 98 =: Basiszone
- 99 =: Sourcezone
- 100 =: Zwischenzellenzone
- 101 =: Gateelektrode
- 101' =: Randgateelektrode
- 102 =: Sourceelektrode

## Patentansprüche

1. Durch Feldeffekt steuerbares Halbleiterbauelement bestehend aus einem Halbleiterkörper (1)
(a) mit einer Innenzone (2) vom ersten Leitungstyp, die an eine Oberfläche (3) des Halbleiterkörpers (1) angrenzt,
(b) mit einer Drainzone (4), die an die Innenzone (2) angrenzt,
(c) mit mehreren Basiszonen (5) vom zweiten dem etsten Leitungstyp entgegengesetzten Leitungstyp, die an der Oberfläche (3) in den Halbleiterkörper (1) eingebettet sind,
(d) mit mehreren Sourcezonen (6) vom ersten Leitungstyp, die jeweils in eine der Basiszonen (5) eingebettet sind,
(e) mit mindestens einer Sourceelektrode (7), die jeweils mindestens eine Basiszone (5) und die darin eingebettete Sourcezone (6) kontaktiert,
(f) mit mindestens einer, gegen den gesamten Halbleiterkörper (1) und gegen die Sourceelektrode (7) isolierten Gateelektrode (8),
(g) wobei in der Innenzone eine Vielzahl von Ausräumzonen (10, 20, 30, 40, 50, 60, 70, 95, 95', 95*) vom zweiten Leitungstyp und eine oder mehrere Komplementärausräumzonen (11, 21, 31, 41, 51, 61, 71, 96, 96', 96*) vom ersten Leitungstyp angeordnet sind,
(h) wobei die Gesamtmenge der Dotierung der Ausräumzonen (10, 20, 30, 40, 50, 60, 70, 95, 95', 95*) in etwa der Gesamtmenge der Dotierung der Komplementärausräumzonen (11, 21, 31, 41, 51, 61, 71, 96, 96', 96*) entspricht,
**dadurch gekennzeichnet, dass**
(i) in den Bereichen (13) zwischen den räumlich voneinander getrennten Basiszonen (5) Gräben (14) vorgesehen sind, die sich von der sourceseitigen Oberfläche (3) in die Innenzone (2) erstrecken, wobei die Ausräumzonen (10) und/oder die Komplementärausräumzonen (11) an den Grabenwänden (15) paarweise angeordnet sind.

2. Halbleiterbauelement nach Anspruch 1,
**dadurch gekennzeichnet,**
**dass** die Gräben (14) mit wenigstens einem Isolator aufgefüllt sind.

3. Halbleiterbauelement nach einem der vorstehenden Ansprüche,
**dadurch gekennzeichnet,**
**dass** die Ausräumzonen (10) und die Komplementärausräumzonen (11) sich bis in die Drainzone (4) erstrecken.

4. Halbleiterbauelement nach einem der vorstehenden Ansprüche,
**dadurch gekennzeichnet,**
**dass** jeweils paarweise zueinander angeordnete Ausräumzonen (10) und die Komplementärausräumzonen (11) an den Grabenwänden vorgesehen sind.

5. Halbleiterbauelement nach Anspruch 4,
**dadurch gekennzeichnet,**
**dass** die paarweise angeordneten Ausräumzonen (10) und Komplementärausräumzonen (11) einen Abstand voneinander größer oder gleich 0 und kleiner oder gleich der Breite der Raumladungszone zwischen den Ausräumzonen (10) und Komplementärausräumzonen (11) aufweisen.

6. Halbleiterbauelement nach einem der vorstehenden Ansprüche,
**dadurch gekennzeichnet,**
**dass** die Ausräumzonen (10) und/oder die Komplementärausräumzonen (11) streifenförmig oder fadenförmig oder in etwa kugelförmig ausgebildet sind.

7. Halbleiterbauelement nach einem der vorstehenden Ansprüche,
**dadurch gekennzeichnet,**
**dass** die Gräben (14) annähernd V-förmig ausgebildet sind.

8. Halbleiterbauelement nach einem der Ansprüche 1 bis 6,
**dadurch gekennzeichnet,**
**dass** die Gräben (14) annähernd U-förmig ausgebildet sind.

9. Halbleiterbauelement nach einem der vorstehenden Ansprüche,
**dadurch gekennzeichnet,**
**dass** unterhalb der Basiszonen (5) an diesen angeschlossene Ausräumzonen (10) und Komplementärausräumzone (11) vorgesehen sind.

10. Halbleiterbauelement nach einem der vorstehenden Ansprüche,
**dadurch gekennzeichnet,**
**dass** im Randbereich des Halbleiterbauelementes Ausräumzonen (95*) und Komplementärausräumzonen (96*) vorgesehen sind, wobei die Ausräumzonen (95*) und Komplementärausräumzonen (96*) im Randbereich schwächer dotiert sind als die Ausräumzonen (95*) und Komplementärausräumzonen (96*) im Inneren des Halbleiterkörpers.

11. Halbleiterbauelement nach einem der vorstehenden Ansprüche,
**dadurch gekennzeichnet,**
**dass** nur ein Teil der Grabenwände (15) mit Ausräumzonen (60) und/oder mit Komplementärausräumzonen (61) belegt ist.

12. Verfahren zur Herstellung eines Halbleiterbauelementes mit zueinander paarweise angeordneten Ausräumzonen (10) und Komplementärausräumzonen (11) nach einem der Ansprüche 1 bis 11,
**gekennzeichnet durch** folgende Verfahrensschritte:
(1) Es wird ein Halbleiterkörper (1) bereitgestellt;
(2) Auf eine erste Oberfläche (3) des Halbleiterkörpers (1) wird eine erste Epitaxieschicht (92') aufgebracht, wobei die erste Epitaxieschicht (92') p-Dotierstoffe und n-Dotierstoffe in etwa gleicher Dosis enthält und wobei sich die Diffusionskoeffizienten der Ionen der beiden Dotierstoffe deutlich voneinander unterscheiden;
(3) In die erste Epitaxieschicht (92') werden Gräbeh (93') geätzt;
(4) Die Gräben (93') werden mit einer zweiten hochohmigen Epitaxieschicht (97') aufgefüllt;
(5) Der so prozessierte Halbleiterkörper (1) wird daraufhin einem Temperschritt unterworfen, bei dem die beiden unterschiedlich schnell diffundierenden Dotierelemente der ersten Epitaxieschicht (92') in die zweite Epitaxieschicht (97') eindiffundieren und aufgrund des unterschiedlichen Diffusionsverhaltens sich paarweise zueinander angeordnete Ausräumzonen (95') und Komplementärausräumzonen (96') an den Grabenrändern ausbilden.

13. Verfahren zur Herstellung eines Halbleiterbauelementes mit Ausräumzonen (10) und Komplementärausräumzonen (11) nach einem der Ansprüche 1 bis 11,
**gekennzeichnet durch** folgende Verfahrensschritte:
(1) Es wird einen Halbleiterkörper (1) bereitgestellt;
(2) Auf eine erste Oberfläche (3) des Halbleiterkörpers (1) wird eine erste Epitaxieschicht (2) aufgebracht,
(3) In die erste Epitaxieschicht (2) werden V-förmige Gräben (14) geätzt;
(4) In die Grabenwände (15) werden Dotieratome zur Erzeugung der Komplementärausräumzonen (11) und/oder Ausräumzonen (10) implantiert;
(5) Der so prozessierte Halbleiterkörper (1) wird daraufhin einem Temperschritt unterworfen, bei dem die Dotierelemente in die Epitaxieschicht (2) und/oder in das Substrat des Halbleiterkörpers (1) eindiffundieren und aufgrund des Diffusionsverhaltens sich Ausräumzonen (95') und/oder Komplementärausräumzonen (96') an den Grabenrändern ausbilden.

14. Verfahren nach Anspruch 13,
**dadurch gekennzeichnet,**
**dass** nur eine Seite der Grabenwand implantiert wird.

15. Verfahren nach einem der Ansprüche 12 bis 14,
**dadurch gekennzeichnet,**
**dass** die Gateelektrode (17, 18) zwei oder mehrteilig ausgestaltet ist und durch die so ausgebildete Gateelektrode (17, 18) ein darunter herzustellender Graben (14) maskiert wird und anschließend unter Verwendung der Gateelektrode (17, 18) als Maske die Gräben (14) geätzt werden.

## Claims

1. Field-effect controllable semiconductor component consisting of a semiconductor body (1)
(a) having an inner zone (2) of the first conduction type, which adjoins a surface (3) of the semiconductor body (1),
(b) having a drain zone (4), which adjoins the inner zone (2),
(c) having a plurality of base zones (5) of the second conduction type, the opposite of the first conduction type, which are embedded at the surface (3) in the semiconductor body (1),
(d) having a plurality of source zones (6) of the first conduction type, which are respectively embedded in one of the base zones (5),
(e) having at least one source electrode (7), which in each case makes contact with at least one base zone (5) and the source zone (6) embedded therein,
(f) having at least one gate electrode (8), which is insulated from the entire semiconductor body (1) and from the source electrode (7),
(g) a multiplicity of depletion zones (10, 20, 30, 40, 50, 60, 70, 95, 95', 95*) of the second conduction type, and one or more complementary depletion zones (11, 21, 31, 41, 51, 61, 71, 96, 96', 96*) of the first conduction type, being arranged in the inner zone,
(h) the total amount of doping of the depletion zones (10, 20, 30, 40, 50, 60, 70, 95, 95', 95*) corresponding'approximately to the total amount of doping of the complementary depletion zones (11, 21, 31, 41, 51, 61, 71, 96, 96', 96*),
**characterised in that**
(i) in the regions (13) between the base zones (5), which are spatially separated from one another, trenches (14) are provided which extend from the source-side surface (3) into the inner zone (2), the depletion zones (10) and/or the complementary depletion zones (11) being arranged in pairs on the trench walls (15).

2. Semiconductor component according to Claim 1,
**characterised in that** the trenches (14) are filled with at least one insulator.

3. Semiconductor component according to one of the preceding claims, **characterised in that** the depletion zones (10) and the complementary depletion zones (11) extend into the drain zone (4).

4. Semiconductor component according to one of the preceding claims, **characterised in that** depletion zones (10), which are in each case arranged in pairs with respect to one another, and the complementary depletion zones (11) are provided on the trench walls.

5. Semiconductor component according to Claim 4,
**characterised in that** the depletion zones (10) and complementary depletion zones (11), which are arranged in pairs, are at a distance from one another which is greater than or equal to 0 and is less than or equal to the width of the space charge zone between the depletion zones (10) and complementary depletion zones (11).

6. Semiconductor component according to one of the preceding claims, **characterised in that** the depletion zones (10) and/or the complementary depletion zones (11) are of strip-shaped or thread-shaped or substantially spherical design.

7. Semiconductor component according to one of the preceding claims, **characterised in that** the trenches (14) are of approximately V-shaped design.

8. Semiconductor component according to one Claims 1 to 6, **characterised in that** the trenches (14) are of approximately U-shaped design.

9. Semiconductor component according to one of the preceding claims, **characterised in that** depletion zones (10) and complementary depletion zones (11), which adjoin the base zones (5), are provided below the base zones (5).

10. Semiconductor component according to one of the preceding claims, **characterised in that** depletion zones (95*) and complementary depletion zones (96*) are provided in the edge region of the semiconductor component, the depletion zones (95*) and complementary depletion zones (96*) in the edge region being doped more weakly than the depletion zones (95*) and complementary depletion zones (96*) in the interior of the semiconductor body.

11. Semiconductor component according to one of the preceding claims, **characterised in that** only part of the trench walls (15) is occupied by depletion zones (60) and/or by complementary depletion zones (61).

12. Process for fabricating a semiconductor component having depletion zones (10) and complementary depletion zones (11), which are arranged in pairs with respect to one another, according to one of Claims 1 to 11, **characterised by** the following process steps:
(1) A semiconductor body (1) is prepared;
(2) A first epitaxial layer (92') is applied to a first surface (3) of the semiconductor body (1), the first epitaxial layer (92') containing p-type dopants and n-type dopants in a substantially equal dose, and the diffusion coefficients of the ions of the two dopants differing significantly from one another;
(3) Trenches (93') are etched into the first epitaxial layer (92');
(4) The trenches (93') are filled with a second high-impedance epitaxial layer (97');
(5) The semiconductor body (1) processed in this way is thereupon subjected to a heat-treatment step, in which the two doping elements of the first epitaxial layer (92'), which diffuse at different rates, diffuse into the second epitaxial layer (97') and, owing to the differing diffusion behaviour, depletion zones (95') and complementary depletion zones (96'), which are arranged in pairs with respect to one another, are formed at the trench edges.

13. Process for fabricating a semiconductor component having depletion zones (10) and complementary depletion zones (11) according to one of Claims 1 to 11, **characterised by** the following process steps:
(1) A semiconductor body (1) is prepared;
(2) A first epitaxial layer (2) is applied to a first surface (3) of the semiconductor body (1);
(3) V-shaped trenches (14) are etched into the first epitaxial layer (2);
(4) Doping atoms are implanted in the trench walls (15) in order to produce the complementary depletion zones (11) and/or depletion zones (10);
(5) The semiconductor body (1) processed in this way is thereupon subjected to a heat-treatment step, in which the doping elements diffuse into the epitaxial layer (2) and/or into the substrate of the semiconductor body (1), and depletion zones (95') and/or complementary depletion zones (96') are formed at the trench edges owing to the diffusion behaviour.

14. Process according to Claim 13, **characterised in that** only one side of the trench wall is implanted.

15. Process according to one of Claims 12 to 14, **characterised in that** the gate electrode (17, 18) is configured in two or more parts, and a trench (14) to be fabricated underneath is masked by the gate electrode (17, 18) formed in this way, and the trenches (14) are subsequently etched by using the gate electrode (17, 18) as a mask.

## Revendications

1. Composant semi-conducteur commandé par effet de champ comprenant un corps semi-conducteur (1) ayant
(a) une zone intérieure (2) d'un premier type de conduction venant à la surface supérieure (3) d'un corps semi-conducteur (1),
(b) une zone de drain (4) adjacente à la zone intérieure (2),
(c) plusieurs zones de base (5) d'un second type de conductivité opposée au premier type de conductivité, et intégrées dans la surface supérieure (3) du corps semi-conducteur (1),
(d) plusieurs zones de source (6) du premier type de conductivité, intégrées chaque fois dans l'une des zones de base (5),
(e) au moins une électrode de source (7) en contact avec au moins une zone de base (5) et avec la zone de source (6) intégrée dans celle-ci,
(f) au moins une électrode de porte (8), isolée par rapport à l'ensemble du corps semi-conducteur (1) et par rapport à une électrode de source (7),
(g) la zone intérieure comportant un grand nombre de zones de dégagement (10, 20, 30, 40, 50, 60, 70, 95, 95', 95*) du second type de conductivité et une ou plusieurs zones de dégagement complémentaires (11, 21, 31, 41, 51, 61, 71, 96, 96', 96*) du premier type de conductivité,
(h) l'ensemble du dopage des zones de dégagement (10, 20, 30, 40, 50, 60, 70, 95, 95', 95*) correspondant sensiblement à l'ensemble du dopage des zones de dégagement complémentaires (11, 21, 31, 41, 51, 61, 71, 96, 96', 96*),
**caractérisé en ce que**,
(i) dans les zones (13) entre les zones de base (5) séparées, il y a des sillons (14) allant de la surface (3) du côté de la source dans la zone intérieure (2), les zones de dégagement (10) et/ou les zones de dégagement complémentaires (11) étant associées par paire au niveau des parois des sillons (15).

2. Composant semi-conducteur selon la revendication 1,
**caractérisé en ce que**
les sillons (14) sont remplis avec au moins un isolant.

3. Composant semi-conducteur selon l'une des revendications précédentes,
**caractérisé en ce que**
les zones de dégagement (10) et les zones de dégagement complémentaires (11) arrivent jusque dans la zone de drain (4).

4. Composant semi-conducteur selon l'une des revendications précédentes,
**caractérisé par**
des paires de zones de dégagement (10) et de zones de dégagement complémentaires (11) associées au niveau des parois des sillons.

5. Composant semi-conducteur selon la revendication 4,
**caractérisé en ce que**
les zones de dégagement (10) et les zones de dégagement complémentaires (11), associées par paire, ont un intervalle respectif supérieur ou égal à 0 et inférieur ou égal à la largeur de la zone de charge d'espace, entre les zones de dégagement (10) et les zones de dégagement complémentaires (11).

6. Composant semi-conducteur selon l'une des revendications précédentes,
**caractérisé en ce que**
les zones de dégagement (10) et/ou les zones de dégagement complémentaires (11) sont réalisées en forme de bandes ou de fils ou suivant une forme sphérique.

7. Composant semi-conducteur selon l'une des revendications précédentes,
**caractérisé en ce que**
les sillons (14) ont une section sensiblement en forme de V.

8. Composant semi-conducteur selon l'une quelconque des revendications 1 à 6,
**caractérisé en ce que**
les sillons (14) ont sensiblement une forme de U.

9. Composant semi-conducteur selon l'une des revendications précédentes,
**caractérisé par**
des zones de dégagement (10) et des zones de dégagement complémentaires (11) adjacentes en dessous des zones de base (5).

10. Composant semi-conducteur selon l'une des revendications précédentes,
**caractérisé en ce que**
dans la zone marginale du composant semi-conducteur, il y a des zones de dégagement (95*) et des zones de dégagement complémentaires (96*), ces zones de dégagement (95*) et ces zones de dégagement complémentaires (96*) étant plus faiblement dopées dans la zone marginale que les zones de dégagement (95*) et les zones de dégagement complémentaires (96*) à l'intérieur du corps semi-conducteur.

11. Composant semi-conducteur selon l'une des revendications précédentes,
**caractérisé en ce que**
seulement une partie des parois de sillons (15) est occupée de zones de dégagement (60) et/ou de zones de dégagement complémentaires (61).

12. Procédé de fabrication d'un composant semi-conducteur avec des zones de dégagement (10) et des zones de dégagement complémentaires (11) associées par paire selon l'une quelconque des revendications 1 à 11,
**caractérisé par** les étapes de procédé suivantes :
1. on réalise un corps semi-conducteur (1),
2. on applique une première couche épitaxiale (92') sur la première surface supérieure (3) du corps semi-conducteur (1),
la première couche épitaxiale (92') ayant un dopage de type p et un dopage de type n suivant sensiblement la même dose et les coefficients de diffusion des deux matières de dopage étant significativement différents,
(1) on grave des sillons (93') dans la première couche épitaxiale (92'),
(2) on remplit les sillons (93') avec une seconde couche épitaxiale (97') fortement ohmique,
(3) on soumet le corps semi-conducteur (1) ainsi traité à une étape de trempe au cours de laquelle les deux éléments de dopage à diffusion à vitesses différentes de la première couche épitaxiale (92') diffusent dans la seconde couche épitaxiale (97') et du fait du comportement de diffusion différent, ils forment des zones de dégagement (95') et des zones de dégagement complémentaires (96') associées par paire au niveau des bords des sillons.

13. Procédé de fabrication d'un composant semi-conducteur avec des zones de dégagement (10) et des zones de dégagement complémentaires (11) selon l'une quelconque des revendications 1 à 11,
**caractérisé par** les étapes suivantes :
(1) on réalise un semi-conducteur (1),
(2) sur la première surface (3) du semi-conducteur (1), on applique une première couche épitaxiale (2),
(3) on grave des sillons (14) à section V dans la première couche épitaxiale (2),
(4) dans les parois des sillons (15), on implante des atomes de dopage pour générer des zones de dégagement complémentaires (11) et/ou des zones de dégagement (10),
(5) on soumet ensuite le corps semi-conducteur (1) ainsi traité à une étape de trempe au cours de laquelle les éléments de dopage diffusent dans la couche épitaxiale (2) et/ou dans le substrat du corps semi-conducteur (1) et du fait du comportement de diffusion, il se forme des zones de dégagement (95') et/ou des zones de dégagement complémentaires (96') au niveau des bords des sillons.

14. Procédé selon la revendication 13,
**caractérisé en ce que**
l'on implante seulement un côté de la paroi du sillon.

15. Procédé selon l'une quelconque des revendications 12 à 14,
**caractérisé en ce qu'**
on réalise l'électrode de porte (17, 18) en deux ou plusieurs parties et on masque par l'électrode de porte (17, 18) ainsi réalisée, un sillon (14) à réaliser en dessous de celle-ci et ensuite en utilisant l'électrode de porte (17, 18) comme masque, on grave les sillons (14).
